# EUROPÄISCHE PATENTSCHRIFT

(11) **EP 3 597 019 B1**
(45) Veröffentlichungstag und Bekanntmachung des Hinweises auf die Patenterteilung: **15.05.2024**
(21) Anmeldenummer: 18711280.0
(22) Anmeldetag: 12.03.2018
(51) Int. Cl.: H05K 5/02, H05K 7/20

(54) **VERFAHREN ZUM KÜHLEN EINES UMRICHTERS, INSBESONDERE EINES FREQUENZUMRICHTERS IN EINEM WÄRMEPUMPENKREISLAUF**
METHOD FOR COOLING A CONVERTER, IN PARTICULAR A FREQUENCY CONVERTER IN A HEAT PUMP CIRCUIT
PROCÉDÉ DE REFROIDISSEMENT D'UN CONVERTISSEUR, EN PARTICULIER D'UN CONVERTISSEUR DE FRÉQUENCE DANS UN CIRCUIT DE POMPE À CHALEUR

(30) Priorität: 17.03.2017 DE 102017204526
(43) Veröffentlichungstag der Anmeldung: 22.01.2020
(73) Patentinhaber: Robert Bosch GmbH, 70442 Stuttgart (DE)
(72) Erfinder: KLINK, Simon, 70794 Filderstadt (DE); FUCHS, Jan Peter, 35396 Giessen (DE)
(86) Internationale Anmeldenummer: PCT/EP2018/056000
(87) Internationale Veröffentlichungsnummer: WO 2018/166935

(56) Entgegenhaltungen:
- EP-A1- 2 083 229
- EP-A1- 2 289 293
- CN-B- 103 023 277
- JP-A- 2010 266 132

## Beschreibung

Die Erfindung betrifft ein Verfahren zum Kühlen eines Umrichters, insbesondere eines Frequenzumrichters in einem Wärmepumpenkreislauf gemäß Patentanspruch 1 und eine Vorrichtung zum Kühlen eines Umrichters in einem Wärmepumpenkreislauf gemäß Patentanspruch 10.

### Stand der Technik

Im Betrieb erzeugen elektronischen und/oder elektrischen Bauelemente, wie sie zum Beispiel in Umrichtern Anwendung finden, meist nicht zu vernachlässigende elektrische Verluste, welche zu einem großen Teil in Verlustwärme umgesetzt werden. Diese Verlustwärme beeinträchtigt die Funktionalität und die Lebensdauer der elektronischen und/oder elektrischen Bauelemente, so dass eine effiziente Wärmeabfuhr der Verlustwärme nötig ist. Grundsätzlich ist eine Kühlung von Umrichtern für Kältekompressoren durch Kältemittel bekannt. Dabei wird das Expansionsventil auf eine bestimmte Überhitzung hin geregelt. Die Umrichterkühlung wird in den vorhandenen Kältemittelkreis integriert. Die Wärmeübertragung findet zwischen elektronischen Bauteilen und dem Kältemittelfluid statt.

Bei einem durch Kältemittel gekühlten Umrichter ist das Risiko besonders hoch, dass die Oberflächentemperatur des Umrichters unter eine von der Luftfeuchte der Umgebung abhängige Taupunktgrenzlinie abfällt und eine Betauung stattfindet. Eine derartige Betauung am Umrichter kann dafür sorgen, dass die elektronischen Bauteile des Umrichters beschädigt und/oder der Umrichter durch entstehende Kurzschlüsse zerstört wird.

Bisher wird das Problem der Betauung bei luftgekühlten Geräten dadurch gelöst, dass über einen Sensor ein Temperatur-Istwert der Komponenten des Gerätes, die vor der Betauung geschützt werden sollen ermittelt wird. Ist dieser Temperatur-Istwert geringer als der vorgegebene Sollwert des Thermostatventils, schließt dieses Ventil. Nachteilig wirkt sich bei der Verwendung eines Thermostatventils aus, dass der vorgegebene Sollwert des Thermostatventils höher oder gleich der Temperatur der Raumluft des Gerätes sein muss. Dadurch wird das Gerät auch dann mit einer hohen Temperatur betrieben, beispielsweise bei einer abgesenkten Raumtemperatur, wenn es nicht erforderlich wäre.

Ferner erweist es sich als nachteilig, dass bei flüssigkeitsgekühlten Geräten meist Thermostatventile verwendet werden, die einen fest vorgegebenen Sollwert haben. Da ein Thermostatventil eine Auf-Zu-Funktionalität aufweist, strömt kaltes Kältemittel in eine Kühlvorrichtung, sobald das Ventil geöffnet ist. Dadurch sinkt die Temperatur dieser Kühlvorrichtung umgehend und das Ventil wird wieder geschlossen. Dadurch erleiden die zu kühlenden Vorrichtungen bei jedem Schaltvorgang des Ventils einen Temperaturzyklus von warm zu kalt zu warm, wodurch ihre Lebensdauer in Mitleidenschaft gezogen wird. Außerdem wird das Gerät immer mit nahezu maximalen Temperaturen betrieben.

EP 2083229 B1 offenbart ein Wärmetauschersystem umfassend: einen ersten Wärmetauscher; einen zweiten Wärmetauscher; einen Kompressor, der auf einem ersten Pfad vorgesehen ist, der einer von zwei Pfaden ist, die den ersten Wärmetauscher und den zweiten Wärmetauscher verbinden, wobei der Kompressor ein Kühlmittel komprimiert; eine variable Drossel, die auf einem zweiten Weg der zwei Wege vorgesehen ist, die den ersten Wärmetauscher und den zweiten Wärmetauscher verbinden, wobei der zweite Weg ein Weg ist, der dem Weg entgegengesetzt ist, auf dem der Kompressor vorgesehen ist; eine feste Drossel, die auf dem zweiten Pfad vorgesehen ist; und ein Kühlelement, das auf dem zweiten Weg vorgesehen ist und das ein zu kühlendes Objekt kühlt, wobei das Kühlelement zwischen der variablen Drossel und der festen Drossel angeordnet ist. JP 2010 266132 A offenbart eine Anordnung eines Wärmetauschersystems zur Miniaturisierung einer mit einem Wechselrichter gekoppelten Kältemaschineneinheit und zur Verhinderung von Taukondensation zu einem Halbleiterelement des Wechselrichters.

### Offenbarung der Erfindung

Der Erfindung liegt nun die Aufgabe zugrunde, ein verbessertes Verfahren zum Kühlen eines Umrichters, insbesondere eines Frequenzumrichters in einem Wärmepumpenkreislauf, sowie eine Vorrichtung zum Schutz eines Umrichters, insbesondere eines Frequenzumrichters in einem Wärmepumpenkreislauf, derart weiterzubilden, dass eine Betauung nebst der oben genannten Nachteile weitestgehend vermieden werden kann.

Diese Aufgabe wird mittels eines Verfahrens gemäß Patentanspruch 1 und eines Wärmepumpenkreislaufs gemäß Patentanspruch 10 gelöst. Vorteilhafte Ausführungsformen sind in den abhängigen Ansprüchen angegeben.

Die Erfindung umfasst ein verbessertes Verfahren zum Kühlen eines Umrichters, insbesondere eines Frequenzumrichters in einem Wärmepumpenkreislauf, wobei der Wärmepumpenkreislauf wenigstens einen ersten Wärmetauscher, einen zweiten Wärmetauscher, und einen dritten Wärmetauscher zum Austauschen von Wärmeenergie zwischen einem Kältemittel und einer Umgebung des jeweiligen Wärmetauschers, umfasst. Ferner weist der Wärmepumpenkreislauf ein Verdichtermodul und ein Expansionsventil auf, wobei das Expansionsventil zwischen dem ersten Wärmetauscher und dem zweiten Wärmetauscher angeordnet ist. Der erste Wärmetauscher, der zweite Wärmetauscher, der dritte Wärmetauscher, das Verdichtermodul sowie das Expansionsventil sind über ein Leitungssystem derart miteinander verbunden, dass das Kältemittel in dem Wärmepumpenkreislauf zirkulieren kann. Hierbei wird das Kältemittel durch Wärmezufuhr in dem Wärmepumpenkreislauf verdampft und anschließend dem dritten Wärmetauscher zur Kühlung des Umrichters zugeführt. Dabei ist der dritte Wärmetauscher dazu eingerichtet, dem Umrichter Wärmeenergie zu entziehen und die Wärmeenergie an das Kältemittel abzugeben. Erfindungsgemäß ist vorgesehen, dass das Expansionsventil derart gesteuert wird, dass eine Oberflächentemperatur des dritten Wärmetauschers stets höher als eine kritische Temperatur ist. Die erfindungsgemäße Ausgestaltung hat den Vorteil, dass der Umrichter auf eine Temperatur erwärmt wird, die oberhalb einer Taupunkttemperatur liegt, so dass eine mögliche Betauung am Umrichter vermieden werden kann.

Grundsätzlich werden elektronisch gesteuerte Expansionsventile dahingehend eingesetzt, dass die Erwärmung des Kältemittels gesteuert werden kann. Diese Ventile können im Bedarfsfall auch vollständig geschlossen werden, um ein Eindringen von flüssigem Kältemittel in den Verdichter, was diesen schwer beschädigen oder zerstören würde, zu verhindern.

Durch das erfindungsgemäße Verfahren wird somit entgegen dem bekannten Stand der Technik die Betauung durch eine Regelung des Expansionsventils verhindert.

Dabei ist es von Vorteil, wenn die kritische Temperatur derart berechnet wird, dass sie einer Taupunkttemperatur der Umgebung des dritten Wärmetauschers entspricht.

In einer bevorzugten Ausführungsform erfolgt die Bestimmung der kritischen Temperatur zumindest teilweise anhand einer gemessenen absoluten Luftfeuchtigkeit der Umgebung des dritten Wärmetauschers sowie anhand einer gemessenen Oberflächentemperatur des dritten Wärmetauschers und/oder zumindest teilweise anhand einer gemessenen absoluten Luftfeuchtigkeit der Umgebung des dritten Wärmetauschers sowie anhand einer gemessenen Temperatur des Kältemittels an einem Ausgang des ersten Wärmetauschers.

Vorzugsweise ist das Expansionsventil ein extern ansteuerbares, insbesondere ein elektronisches Expansionsventil, wobei ein Öffnungsgrad des Expansionsventils unabhängig von anderen Kenngrößen des Wärmepumpenkreislaufes eingestellt werden kann. Typischerweise wird die Ventilposition, d. h. der Öffnungsgrad, durch einen Schrittmotor eingestellt. Zur Vermeidung einer Betauung wird somit eine bekannte Expansionsventilregelung um Regelalgorithmen ergänzt, welche einen Wert der Erwärmung erreicht, wenn eine mögliche Betauung aufgrund aktueller System- und Umgebungsbedingungen auftreten könnte.

Zur Implementierung des zusätzlichen Reglers zur Betauungsverhinderung bestehen grundsätzlich verschiedenen regelungstechnische Umsetzungsmöglichkeiten. Vorteilhafterweise basiert eine Steuerung des Expansionsventils auf einer Fuzzy-Logik, einer strukturvariablen Regelung, oder auf einer Sollgrößenänderung bei entsprechend ausgelegtem Folgeverhalten. Zur Berechnung der Sollwerte wird eine Vorsteuerung eingesetzt. Dabei bietet die Anwendung erweiterter Regelalgorithmen deutliche Vorteile gegenüber den bekannten Umsetzungen zur Betauungsvermeidung, da das ohnehin im Kühlkreislauf verwendete Expansionsventil zusätzlich auch noch zur Betauungsverhinderung am Umrichter genutzt werden kann. Besonders bei Einsatz der Wärmepumpe im Kühlbetrieb ergeben sich Vorteile, da bei entsprechender Regelung des Expansionsventils die Kältemitteltemperatur über der Taupunktemperatur liegt.

In einer weiteren Ausführungsform beinhaltet die Steuerung des Expansionsventils, dass eine Durchflussöffnung des Expansionsventils verkleinert wird, wenn die Oberflächentemperatur des dritten Wärmetauschers ein Temperatur unterschreitet, die um ein definiertes Maß höher ist als die kritische Temperatur. Auf diese Weise wird bei bevorstehender Kondensation von der aktuellen Regelstrategie auf Kühlen des Umrichters zur Betauungsverhinderung umgeschaltet. Dies hat eine Erhöhung der Kältemitteltemperatur durch Reduktion der Expansionsventilöffnung zur Folge. Durch diese erfindungsgemäße Regelung des Kältemittelvolumenstromes wird einerseits dafür gesorgt, dass eine zu kühlende Vorrichtung sich im sicheren Arbeitsbereich befindet, und andererseits sich eine Temperatur einstellt, die oberhalb des Taupunkts der Umgebung liegt.

Bevorzugterweise ist der erste Wärmetauscher ein Verdampfermodul zur Verdampfung des Kältemittels und der zweite Wärmetauscher ein Kondensatormodul zur Verflüssigung des Kältemittels.

In einer alternativen Ausführungsform ist der erste Wärmetauscher ein Kondensatormodul zur Verflüssigung des Kältemittels und der zweite Wärmetauscher ein Verdampfermodul zur Verdampfung des Kältemittels ist.

In einer weiteren Ausführungsform ist der Frequenzumrichter dazu eingerichtet, einen Verdichtermotor des Verdichtermoduls hinsichtlich einer Drehzahl des Verdichtermotors zu regeln.

Einen weiteren Gegenstand der vorliegenden Erfindung bildet eine Vorrichtung zum Kühlen eines Umrichters in einem Wärmepumpenkreislauf. Die Vorrichtung umfasst einen ersten Wärmetauscher, einen zweiten Wärmetauscher, und einen dritten Wärmetauscher zum Austauschen von Wärmeenergie zwischen einem Kältemittel und einer Umgebung des jeweiligen Wärmetauschers. Ferner weist die Vorrichtung ein Verdichtermodul und ein Expansionsventil auf, wobei das Expansionsventil zwischen dem ersten Wärmetauscher und dem zweiten Wärmetauscher angeordnet ist. Dabei sind der erste Wärmetauscher, der zweite Wärmetauscher, der dritte Wärmetauscher, das Verdichtermodul sowie das Expansionsventil über ein Leitungssystem derart miteinander verbunden, dass das Kältemittel in dem Wärmepumpenkreislauf zirkulieren kann, wobei der dritte Wärmetauscher dazu eingerichtet ist, dem Umrichter Wärmeenergie zu entziehen und die Wärmeenergie an das Kältemittel abzugeben. Erfindungsgemäß wird das Kältemittel durch Wärmezufuhr in dem Wärmepumpenkreislauf verdampft und anschließend dem dritten Wärmetauscher zur Kühlung des Umrichters zugeführt.

Erfindungsgemäß ist vorgesehen, dass die Vorrichtung ferner eine Steuereinheit umfasst, wobei die Steuereinheit dazu eingerichtet ist, das Expansionsventil derart zu steuern, dass eine Oberflächentemperatur des dritten Wärmetauschers stets höher als eine kritische Temperatur ist. Hierfür wird das genannte Expansionsventil um ein bestimmtes Maß mehr geschlossen als zur eigentlichen Aufrechterhaltung der Überhitzung notwendig ist. Dadurch steigt die Temperatur des Kältemittels. Dies bewirkt ein Ansteigen der Oberflächentemperatur am Umrichter. Auf diese Weise wird nicht nur eine ausreichende Temperaturregelung des Kältemittels beim Kompressoreintritt sichergestellt, sondern auch, dass die Oberflächentemperatur des Umrichters oberhalb der Taupunktgrenzlinie liegt.

In einer erfindungsgemäßen Ausgestaltung umfasst die Vorrichtung ferner einen Feuchtigkeitssensor zur Bestimmung einer absoluten Luftfeuchtigkeit der Umgebung des dritten Wärmetauschers sowie wenigstens einen ersten Temperatursensor zur Bestimmung einer Oberflächentemperatur des dritten Wärmetauschers, und/oder wenigstens einen zweiten Temperatursensor zur Bestimmung einer Temperatur des Kältemittels an einem Ausgang des ersten Wärmetauschers und/oder wenigstens einen dritten Temperatursensor zur Bestimmung einer Temperatur des Kältemittels an einem Eingang des dritten Wärmetauschers und/oder einen vierten Temperatursensor zur Bestimmung einer Temperatur des Kältemittels stromaufwärts eines Eingangs des dritten Wärmetauschers.

Vorteilhafterweise ist das Expansionsventil ein extern ansteuerbares, insbesondere ein elektronisches Expansionsventil, wobei ein Öffnungsgrad des Expansionsventils unabhängig von anderen Kenngrößen des Wärmepumpenkreislaufes einstellbar ist.

Bevorzugterweise ist der erste Wärmetauscher ein Verdampfermodul zur Verdampfung des Kältemittels und der zweite Wärmetauscher ein Kondensatormodul zur Verflüssigung des Kältemittels.

In einer alternativen Ausführungsform ist der erste Wärmetauscher ein Kondensatormodul zur Verflüssigung des Kältemittels und der zweite Wärmetauscher ein Verdampfermodul zur Verdampfung des Kältemittels ist.

In einer vorteilhaften Ausgestaltung ist der Umrichter dazu eingerichtet, einen Verdichtermotor des Verdichtermoduls hinsichtlich einer Drehzahl des Verdichtermotors zu regeln.

In einer besonders bevorzugten Ausführungsform umfasst die Vorrichtung desweiteren ein 4-Wege-Ventil, wobei das 4-Wege-Ventil dazu eingerichtet ist, die Flussrichtung des Kälteventils in dem Wärmepumpenkreislauf zu steuern. Dabei ist es von Vorteil, wenn das 4-Wege-Ventil insbesondere dazu eingerichtet ist, die Flussrichtung des Kältemittels derart zu steuern, dass der erste Wärmetauscher als Kondensator und der zweite Wärmetauscher als Verdampfer des Wärmepumpenkreislaufes arbeitet.

Dabei soll grundsätzlich unter steuern der Flussrichtung verstanden werden, dass das 4-Wege-Ventil dazu eingerichtet die Flussrichtung des Kältemittels im Wärmepumpenkreislauf umzuschalten bzw. umzukehren. Auf diese Weise kann gewährleistet werden, dass die Wärmepumpe bzw. der Wärmepumpenkreislauf sowohl in einem Kühlbetrieb als auch in einem Heizbetrieb verwendet werden kann und die physikalischen Bauteile Kondensator und Verdampfer je nach Einstellung des 4-Wege-Ventils ihre Funktion tauschen. So ist in einem Heizbetrieb die Vorrichtung so geschaltet ist, dass das Kältemittel zum Verdampfer geleitet wird und dort Wärme an die Umgebung abgibt, und in einem Kühlbetrieb entsprechend die Wärme aus der Umgebung aufnimmt und im Kondensator wieder abgibt.

Weitere Merkmale, Anwendungsmöglichkeiten und Vorteile der Erfindung ergeben sich aus der nachfolgenden Beschreibung der Ausführungsbeispiele der Erfindung, welche in den Figuren dargestellt sind. Dabei ist zu beachten, dass die dargestellten Merkmale nur einen beschreibenden Charakter haben und auch in Kombination mit Merkmalen anderer oben beschriebener Weiterentwicklungen verwendet werden können und nicht dazu gedacht sind, die Erfindung in irgendeiner Form einzuschränken.

### Zeichnungen

Die Erfindung wird im Folgenden anhand von bevorzugten Ausführungsbeispielen näher erläutert, wobei für gleiche Merkmale gleiche Bezugszeichen verwendet werden. Die Zeichnungen sind schematisch und zeigen:
- Figur 1: eine schematische Darstellung eines Wärmepumpenkreislaufs im Heizbetrieb;
- Figur 2: eine schematische Darstellung eines Wärmepumpenkreislaufs im Kühlbetrieb; und
- Figur 3: ein schematischer Aufbau eines erfindungsgemäßen Regelkonzepts.

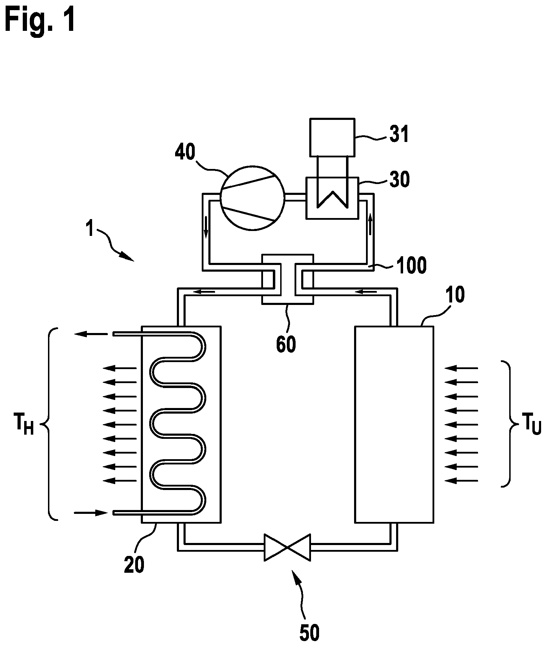

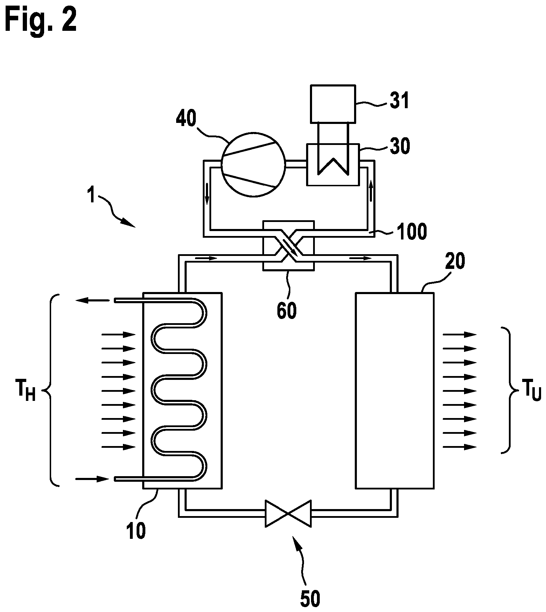

Die Figuren 1 und 2 stellen jeweils eine schematische Darstellung eines Wärmepumpenkreislauflaufs 1 dar, wobei der Wärmepumpenkreislauf 1 wie in Figur 1 im Heizbetrieb oder wie in Figur 2 im Kühlbetrieb betrieben werden kann.

Der Wärmepumpenkreislauf 1 umfasst einen Umrichter 31, einen ersten Wärmetauscher 10, einen zweiten Wärmetauscher 20 und einen dritten Wärmetauscher 30 zum Austauschen von Wärmeenergie zwischen einem Kältemittel und einer Umgebung des jeweiligen Wärmetauschers 10, 20, 30. Ferner umfasst der Wärmepumpenkreislauf 1 ein Verdichtermodul 40 und ein Expansionsventil 50, wobei das Expansionsventil 50 zwischen dem ersten Wärmetauscher 10 und dem zweiten Wärmetauscher 20 angeordnet ist.

Wie in den Figuren 1 und 2 dargestellt, wird in einem einstufigen Wärmepumpenkreislauf 1 das Expansionsventil 50 zur Regelung der Temperatur verwendet, wobei auch bei einem nicht dargestellten mehrstufigen Wärmepumpenkreislauf 1 die Kühlung des Umrichters 31 auf Mitteldruckniveau erfolgen kann, sofern es sich um ein extern ansteuerbares Expansionsventil 50 handelt und der Öffnungsgrad des Expansionsventils 50 unabhängig vom Systemzustand bzw. anderen Kenngrößen des Wärmepumpenkreislaufs 1 eingestellt werden kann. Der Umrichter 31 ist dazu eingerichtet, einen nicht im Detail dargestellten Verdichtermotor des Verdichtermoduls 40 hinsichtlich einer Drehzahl des Verdichtermotors zu regeln.

Der erste Wärmetauscher 10, der zweite Wärmetauscher 20, der dritte Wärmetauscher 30, das Verdichtermodul 40 sowie das Expansionsventil 50 sind über ein Leitungssystem 100 miteinander verbunden. Ferner umfasst der Wärmepumpenkreislauf 1 ein Kältemittel, welches in dem Wärmepumpenkreislauf 1 zirkulieren kann. Das Kältemittel kann beispielsweise Propan, Butan und/oder CO2 aufweisen.

Der dritte Wärmetauscher 30 ist dazu eingerichtet, dem Umrichter 31 Wärmeenergie zu entziehen und die Wärmeenergie an das Kältemittel abzugeben. Das Kältemittel wird durch Wärmezufuhr im Wärmepumpenkreislauf 1 verdampft und anschließend dem dritten Wärmetauscher 30 zur Kühlung des Umrichters 31 zugeführt. Erfindungsgemäß ist vorgesehen, dass das Expansionsventil 50 derart über eine nicht dargestellte Steuerung gesteuert wird, dass eine Oberflächentemperatur des dritten Wärmetauschers 30 stets höher als eine kritische Temperatur ist. Dabei wird die kritische Temperatur derart berechnet, dass sie einer Taupunkttemperatur der Umgebung des dritten Wärmetauschers 30 entspricht. Die Bestimmung der kritischen Temperatur erfolgt zumindest teilweise anhand einer gemessenen absoluten Luftfeuchtigkeit der Umgebung des dritten Wärmetauschers 30 sowie anhand einer gemessenen Oberflächentemperatur des dritten Wärmetauschers 30. Desweiteren erfolgt die Bestimmung der kritischen Temperatur zumindest teilweise anhand einer gemessenen absoluten Luftfeuchtigkeit der Umgebung des dritten Wärmetauschers 30 sowie anhand einer gemessenen Temperatur des Kältemittels an einem Ausgang des ersten Wärmetauschers 10.

Zur Bestimmung einer absoluten Luftfeuchtigkeit der Umgebung des dritten Wärmetauschers 30 umfasst der Wärmepumpenkreislauf 1 einen Feuchtigkeitssensor. Zur Bestimmung einer Oberflächentemperatur des dritten Wärmetauschers 30 umfasst der Wärmepumpenkreislauf 1 ferner wenigstens einen ersten Temperatursensor und zur Bestimmung einer Temperatur des Kältemittels an einem Ausgang des ersten Wärmetauschers 10 umfasst der Wärmepumpenkreislauf 1 wenigstens einen zweiten Temperatursensor. Nicht im Detail in den Figuren dargestellt, aber alternativ oder zusätzlich sind weitere Temperatursensoren denkbar, so dass der Wärmepumpenkreislauf 1 beispielsweise ein dritte Temperatursensor zur Bestimmung einer Temperatur des Kältemittels an einem Eingang des dritten Wärmetauschers 30 und/oder ein vierten Temperatursensor zur Bestimmung einer Temperatur des Kältemittels stromaufwärts eines Eingangs des dritten Wärmetauschers umfassen kann.

Grundsätzlich ist vorgesehen, dass die Steuerung des Expansionsventils 50 auf einer Fuzzy-Logik, einer strukturvariablen Regelung oder auf einer Sollgrößenänderung basiert, wobei die Steuerung des Expansionsventils 50 beinhaltet, dass eine Durchflussöffnung des Expansionsventils 50 verkleinert wird, wenn die Oberflächentemperatur des dritten Wärmetauschers 30 ein Temperatur unterschreitet, die um ein definiertes Maß höher ist als die kritische Temperatur.

Ferner umfasst die Vorrichtung ein 4-Wege-Ventil 60, mit welchem die Flussrichtung des Kältemittels in dem Wärmepumpenkreislauf 1 gesteuert werden kann.

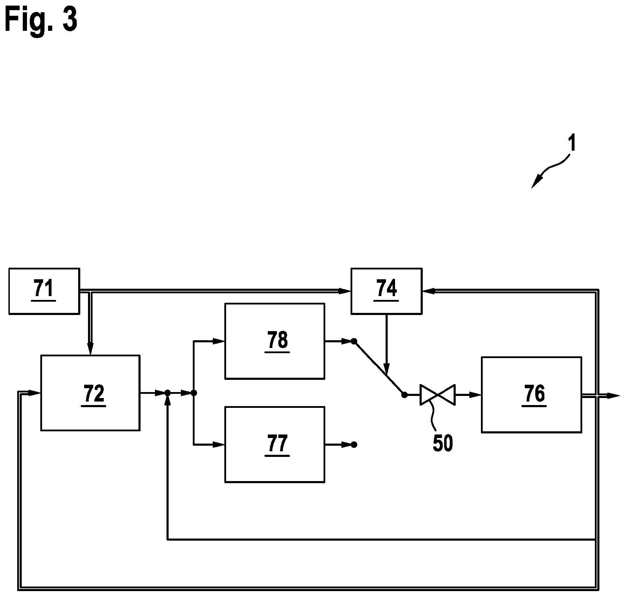

Die Figur 3 stellt einen schematischen Aufbau des Regelungskonzeptes dar. Anhand der Umgebungsbedingungen 71 und des Wärmepumpenkreislaufs 1 erfolgen die Sollwertbestimmung 72 sowie die Auswertung der Umschaltstrategie 74 für die Regelung 76. Ist der festgelegte Grenzwert T_{grenz} zum aktuellen Taupunkt T_{Taup}. Unterschritten, wird von Überhitzungsregelung 77 auf Betauungsregelung 78 umgeschaltet.

Für den Übergang der Sollwertbestimmung 72 wird eine Trajektorie entworfen, welche einen weichen Übergang der Stellgröße gewährleistet. Solange das Betauungsrisiko besteht wird der Wärmepumpenkreislauf 1 mit der Betauungsregelung 78 betrieben. Ändern sich System- oder Umgebungsbedingungen, sodass kein Betauungsrisiko mehr besteht, wird erneut umgeschaltet, um die Überhitzungsregelung 77 zu aktivieren. Da die Sollüberhitzungen während der Betauungsregelung 78 durchweg höher sind als bei der Überhitzungsregelung 77, besteht während des Betauungsregelung 78 keine Gefahr des Ansaugens von flüssigem Kältemittel durch den Kompressor. In der Umgebung des Umrichters 31 sind die Umgebungstemperatur T_{Umgebung} und die relative Luftfeuchtigkeit zu messen. Diese Messgrößen sind in Figur 3 unter dem Begriff der Umgebungsbedingungen 71 zusammengefasst. Die Oberflächentemperatur des Umrichters kann entweder direkt erfasst werden oder anhand der Kältemitteltemperatur am Ausgang des Verdampfers, in Figur 1 anhand der Kältemitteltemperatur am Ausgang des ersten Wärmetauschers 10 und in Figur 2 anhand der Kältemitteltemperatur am Ausgang des zweiten Wärmetauschers 20, abgeschätzt werden.

Die Erfindung ist nicht auf das beschriebene und dargestellte Ausführungsbeispiel beschränkt. Sie umfasst vielmehr auch alle fachmännischen Weiterbildungen im Rahmen der durch die Patentansprüche definierten Erfindung.

Neben den beschriebenen und abgebildeten Ausführungsformen sind weitere Ausführungsformen vorstellbar, welche weitere Abwandlungen sowie Kombinationen von Merkmalen umfassen können.

## Patentansprüche

1. Verfahren zum Kühlen eines Umrichters (31), insbesondere eines Frequenzumrichters in einem Wärmepumpenkreislauf (1), der Wärmepumpenkreislauflauf (1) umfassend
• einen ersten Wärmetauscher (10), einen zweiten Wärmetauscher (20), und einen dritten Wärmetauscher (30) zum Austauschen von Wärmeenergie zwischen einem Kältemittel und einer Umgebung des jeweiligen Wärmetauschers (10, 20, 30),
• ein Verdichtermodul (40),
• ein Expansionsventil (50 ), wobei das Expansionsventil (50) zwischen dem ersten Wärmetauscher (10) und dem zweiten Wärmetauscher (20) angeordnet ist;
wobei der erste Wärmetauscher (10), der zweite Wärmetauscher (20), der dritte Wärmetauscher (30), das Verdichtermodul (40) sowie das Expansionsventil (50) über ein Leitungssystem (100) derart miteinander verbunden sind, dass das Kältemittel in dem Wärmepumpenkreislauf (1) zirkulieren kann,
wobei der dritte Wärmetauscher (30) dazu eingerichtet ist, dem Umrichter (31) Wärmeenergie zu entziehen und die Wärmeenergie an das Kältemittel abzugeben,
wobei das Expansionsventil (50) derart gesteuert wird, dass eine Oberflächentemperatur des dritten Wärmetauschers (30) stets höher als eine kritische Temperatur ist,
**dadurch gekennzeichnet, dass**
das Kältemittel durch Wärmezufuhr in dem Wärmepumpenkreislauf (1) verdampft und anschließend dem dritten Wärmetauscher (30) zur Kühlung des Umrichters (31) zugeführt wird.

2. Verfahren nach Anspruch 1, **dadurch gekennzeichnet, dass** die kritische Temperatur derart berechnet wird, dass sie einer Taupunkttemperatur der Umgebung des dritten Wärmetauschers (30) entspricht.

3. Verfahren nach Anspruch 1 oder 2, **dadurch gekennzeichnet, dass** die Bestimmung der kritischen Temperatur zumindest teilweise anhand einer gemessenen absoluten Luftfeuchtigkeit der Umgebung des dritten Wärmetauschers (30) sowie anhand einer gemessenen Oberflächentemperatur des dritten Wärmetauschers (30) erfolgt, und/oder dass die Bestimmung der kritischen Temperatur zumindest teilweise anhand einer gemessenen absoluten Luftfeuchtigkeit der Umgebung des dritten Wärmetauschers (30) sowie anhand einer gemessenen Temperatur des Kältemittels an einem Ausgang des ersten Wärmetauschers (10) erfolgt.

4. Verfahren nach einem der vorstehenden Ansprüche, **dadurch gekennzeichnet, dass** das Expansionsventil (50) ein extern ansteuerbares, insbesondere ein elektronisches Expansionsventil ist, wobei ein Öffnungsgrad des Expansionsventils (50) unabhängig von anderen Kenngrößen des Wärmepumpenkreislaufs (1) eingestellt werden kann.

5. Verfahren nach einem der vorstehenden Ansprüche, **dadurch gekennzeichnet, dass** eine Steuerung des Expansionsventils (50) auf einer Fuzzy-Logik, einer strukturvariablen Regelung, oder auf einer Sollgrößenänderung basiert.

6. Verfahren nach Anspruch 5, **dadurch gekennzeichnet, dass** die Steuerung des Expansionsventils (50) beinhaltet, dass eine Durchflussöffnung des Expansionsventils (50) verkleinert wird, wenn die Oberflächentemperatur des dritten Wärmetauschers (30) ein Temperatur unterschreitet, die um ein definiertes Maß höher ist als die kritische Temperatur.

7. Verfahren nach einem der vorhergehenden Ansprüche, **dadurch gekennzeichnet, dass** der erste Wärmetauscher (10) ein Verdampfermodul zur Verdampfung des Kältemittels ist.

8. Verfahren nach einem der vorhergehenden Ansprüche, **dadurch gekennzeichnet, dass** der zweite Wärmetauscher (20) ein Kondensatormodul zur Verflüssigung des Kältemittels ist.

9. Verfahren nach einem der vorhergehenden Ansprüche, **dadurch gekennzeichnet, dass** der Frequenzumrichter (10) dazu eingerichtet ist, einen Verdichtermotor (42) des Verdichtermoduls (40) hinsichtlich einer Drehzahl des Verdichtermotors (42) zu regeln.

10. Vorrichtung zum Kühlen eines Umrichters (31), insbesondere eines Frequenzumrichters in einem Wärmepumpenkreislauf (1) umfassend
• einen ersten Wärmetauscher (10), einen zweiten Wärmetauscher (20), und einen dritten Wärmetauscher (30) zum Austauschen von Wärmeenergie zwischen einem Kältemittel und einer Umgebung des jeweiligen Wärmetauschers (10, 20, 30),
• ein Verdichtermodul (40),
• ein Expansionsventil (50), wobei das Expansionsventil (50) zwischen dem ersten Wärmetauscher (10) und dem zweiten Wärmetauscher (20) angeordnet ist,
wobei der erste Wärmetauscher (10), der zweite Wärmetauscher (20), der dritte Wärmetauscher (30), das Verdichtermodul (40) sowie das Expansionsventil (50) über ein Leitungssystem (100) derart miteinander verbunden sind, dass das Kältemittel in dem Wärmepumpenkreislauf (1) zirkulieren kann,
wobei der dritte Wärmetauscher (30) dazu eingerichtet ist, dem Umrichter (31) Wärmeenergie zu entziehen und die Wärmeenergie an das Kältemittel abzugeben, und
wobei
die Vorrichtung ferner eine Steuereinheit (200) umfasst, wobei die Steuereinheit (200) dazu eingerichtet ist, das Expansionsventil (50) derart zu steuern, dass eine Oberflächentemperatur des dritten Wärmetauschers (30) stets höher als eine kritische Temperatur ist,
**dadurch gekennzeichnet, dass**
das Kältemittel durch Wärmezufuhr in dem Wärmepumpenkreislauf (1) verdampft und anschließend dem dritten Wärmetauscher (30) zur Kühlung des Umrichters (31) zugeführt wird.

11. Vorrichtung nach Anspruch 10, **dadurch gekennzeichnet, dass** sie fernereinen Feuchtigkeitssensor zur Bestimmung einer absoluten Luftfeuchtigkeit der Umgebung des dritten Wärmetauschers (30) umfasst sowie wenigstens einen ersten Temperatursensor zur Bestimmung einer Oberflächentemperatur des dritten Wärmetauschers (30), und/oder wenigstens einen zweiten Temperatursensor zur Bestimmung einer Temperatur des Kältemittels an einem Ausgang des ersten Wärmetauschers (10) und/oder wenigstens einen dritten Temperatursensor zur Bestimmung einer Temperatur des Kältemittels an einem Eingang des dritten Wärmetauschers (30) und/oder einen vierten Temperatursensor zur Bestimmung einer Temperatur des Kältemittels stromaufwärts eines Eingangs des dritten Wärmetauschers (30).

12. Vorrichtung nach einem der Ansprüche 10 oder 11, **dadurch gekennzeichnet, dass** das Expansionsventil (50) ein extern ansteuerbares, insbesondere ein elektronisches Expansionsventil ist, wobei ein Öffnungsgrad des Expansionsventils (50) unabhängig von anderen Kenngrößen des Wärmepumpenkreislaufs (1) einstellbar ist.

13. Vorrichtung nach einem der Ansprüche 10 bis 12, **dadurch gekennzeichnet, dass** der erste Wärmetauscher (10) ein Verdampfermodul zur Verdampfung des Kältemittels und dass der zweite Wärmetauscher (20) ein Kondensatormodul zur Verflüssigung des Kältemittels ist.

14. Vorrichtung nach einem der Ansprüche 10 bis 12, **dadurch gekennzeichnet, dass** der erste Wärmetauscher (10) ein Kondensatormodul zur Verflüssigung des Kältemittels und dass zweite Wärmetauscher (20) ein Verdampfermodul zur Verdampfung des Kältemittels ist.

15. Vorrichtung nach einem der Ansprüche 10 bis 14, **dadurch gekennzeichnet, dass** der Umrichter (31) dazu eingerichtet ist, einen Verdichtermotor (42) des Verdichtermoduls (40) hinsichtlich einer Drehzahl des Verdichtermotors (42) zu regeln.

16. Vorrichtung nach einem der Ansprüche 10 bis 15, **dadurch gekennzeichnet, dass** die Vorrichtung des weiteren ein 4-Wege-Ventil umfasst, wobei das 4-Wege-Ventil (60) dazu eingerichtet ist, die Flussrichtung des Kältemittels in dem Wärmepumpenkreislauf (1) zu steuern.

17. Vorrichtung nach Anspruch 16, **dadurch gekennzeichnet, dass** das 4-Wege-Ventil (60) insbesondere dazu eingerichtet ist, die Flussrichtung des Kältemittels derart zu steuern, dass der erste Wärmetauscher (10) wahlweise als ein Verdampfermodul oder als Kondensatormodul und der zweite Wärmetauscher (20) dementsprechend als Kondensatormodul oder als ein Verdampfermodul des Wärmepumpenkreislaufs (1) arbeitet.

## Claims

1. Method for cooling a converter (31), in particular a frequency converter in a heat-pump circuit (1), the heat-pump circuit (1) comprising:
• a first heat exchanger (10), a second heat exchanger (20) and a third heat exchanger (30) for exchange of thermal energy between a refrigerant and surroundings of the respective heat exchanger (10, 20, 30),
• a compressor module (40),
• an expansion valve (50), wherein the expansion valve (50) is arranged between the first heat exchanger (10) and the second heat exchanger (20) ;
wherein the first heat exchanger (10), the second heat exchanger (20), the third heat exchanger (30), the compressor module (40) and the expansion valve (50) are connected to one another via a line system (100) in such a way that the refrigerant can circulate in the heat-pump circuit (1),
wherein the third heat exchanger (30) is configured to extract thermal energy from the converter (31) and to release the thermal energy to the refrigerant,
wherein the expansion valve (50) is controlled in such a way that a surface temperature of the third heat exchanger (30) is at all times higher than a critical temperature,
**characterized in that**
the refrigerant evaporates by heat being supplied to the heat-pump circuit (1) and is then supplied to the third heat exchanger (30) for cooling the converter (31).

2. Method according to Claim 1, **characterized in that** the critical temperature is calculated in such a way that it corresponds to a dew-point temperature of the surroundings of the third heat exchanger (30).

3. Method according to Claim 1 or 2, **characterized in that** the critical temperature is determined at least partially on the basis of a measured absolute air humidity of the surroundings of the third heat exchanger (30) and on the basis of a measured surface temperature of the third heat exchanger (30), and/or **in that** the critical temperature is determined at least partially on the basis of a measured absolute air humidity of the surroundings of the third heat exchanger (30) and on the basis of a measured temperature of the refrigerant at an exit of the first heat exchanger (10).

4. Method according to one of the preceding claims, **characterized in that** the expansion valve (50) is an externally actuatable, in particular an electronic, expansion valve, wherein a degree of opening of the expansion valve (50) can be set independently of other characteristic variables of the heat-pump circuit (1).

5. Method according to one of the preceding claims, **characterized in that** control of the expansion valve (50) is based on fuzzy logic, variable-structure control, or on target-variable changing.

6. Method according to Claim 5, **characterized in that** the control of the expansion valve (50) includes reduction in size of a throughflow opening of the expansion valve (50) if the surface temperature of the third heat exchanger (30) falls below a temperature which is higher than the critical temperature by a defined amount.

7. Method according to one of the preceding claims, **characterized in that** the first heat exchanger (10) is an evaporator module for evaporating the refrigerant.

8. Method according to one of the preceding claims, **characterized in that** the second heat exchanger (20) is a condenser module for liquefying the refrigerant.

9. Method according to one of the preceding claims, **characterized in that** the frequency converter (10) is configured to regulate a compressor motor (42) of the compressor module (40) in terms of a rotational speed of the compressor motor (42).

10. Apparatus for cooling a converter (31), in particular a frequency converter in a heat-pump circuit (1) comprising:
• a first heat exchanger (10), a second heat exchanger (20) and a third heat exchanger (30) for exchange of thermal energy between a refrigerant and surroundings of the respective heat exchanger (10, 20, 30),
• a compressor module (40),
• an expansion valve (50), wherein the expansion valve (50) is arranged between the first heat exchanger (10) and the second heat exchanger (20) ;
wherein the first heat exchanger (10), the second heat exchanger (20), the third heat exchanger (30), the compressor module (40) and the expansion valve (50) are connected to one another via a line system (100) in such a way that the refrigerant can circulate in the heat-pump circuit (1),
wherein the third heat exchanger (30) is configured to extract thermal energy from the converter (31) and to release the thermal energy to the refrigerant, and
wherein
the apparatus furthermore comprises a control unit (200), wherein the control unit (200) is configured to control the expansion valve (50) in such a way that a surface temperature of the third heat exchanger (30) is at all times higher than a critical temperature,
**characterized in that**
the refrigerant evaporates by heat being supplied to the heat-pump circuit (1) and is then supplied to the third heat exchanger (30) for cooling the converter (31).

11. Apparatus according to Claim 10, **characterized in that** said apparatus furthermore comprises a humidity sensor for determining an absolute air humidity of the surroundings of the third heat exchanger (30) and at least one first temperature sensor for determining a surface temperature of the third heat exchanger (30), and/or at least one second temperature sensor for determining a temperature of the refrigerant at an exit of the first heat exchanger (10) and/or at least one third temperature sensor for determining a temperature of the refrigerant at an entry of the third heat exchanger (30) and/or a fourth temperature sensor for determining a temperature of the refrigerant upstream of an entry of the third heat exchanger (30) .

12. Apparatus according to either of Claims 10 and 11, **characterized in that** the expansion valve (50) is an externally actuatable, in particular an electronic, expansion valve, wherein a degree of opening of the expansion valve (50) can be set independently of other characteristic variables of the heat-pump circuit (1).

13. Apparatus according to one of Claims 10 to 12, **characterized in that** the first heat exchanger (10) is an evaporator module for evaporating the refrigerant, and **in that** the second heat exchanger (20) is a condenser module for liquefying the refrigerant.

14. Apparatus according to one of Claims 10 to 12, **characterized in that** the first heat exchanger (10) is a condenser module for liquefying the refrigerant, and **in that** the second heat exchanger (20) is an evaporator module for evaporating the refrigerant.

15. Apparatus according to one of Claims 10 to 14, **characterized in that** the converter (31) is configured to regulate a compressor motor (42) of the compressor module (40) in terms of a rotational speed of the compressor motor (42).

16. Apparatus according to one of Claims 10 to 15, **characterized in that** the apparatus furthermore comprises a 4-way valve, wherein the 4-way valve (60) is configured to control the flow direction of the refrigerant in the heat-pump circuit (1).

17. Apparatus according to Claim 16, **characterized in that** the 4-way valve (60) is configured in particular to control the flow direction of the refrigerant in such a way that the first heat exchanger (10) selectively operates as an evaporator module or as a condenser module and the second heat exchanger (20) correspondingly operates as a condenser module or as an evaporator module of the heat-pump circuit (1).

## Revendications

1. Procédé de refroidissement d'un convertisseur (31), en particulier d'un convertisseur de fréquence, dans un circuit de pompe à chaleur (1), le circuit de pompe à chaleur (1) comprenant
• un premier échangeur de chaleur (10), un deuxième échangeur de chaleur (20) et un troisième échangeur de chaleur (30) servant à échanger de l'énergie thermique entre un réfrigérant et un environnement de l'échangeur de chaleur (10, 20, 30) respectif,
• un module compresseur (40),
• une vanne de détente (50), la vanne de détente (50) étant disposée entre le premier échangeur de chaleur (10) et le deuxième échangeur de chaleur (20) ;
le premier échangeur de chaleur (10), le deuxième échangeur de chaleur (20), le troisième échangeur de chaleur (30), le module compresseur (40) ainsi que la vanne de détente (50) étant reliés les uns aux autres par un système de conduits (100) de telle sorte que le réfrigérant peut circuler dans le circuit de pompe à chaleur (1),
le troisième échangeur de chaleur (30) étant conçu pour extraire de l'énergie thermique du convertisseur (31) et pour libérer l'énergie thermique vers le réfrigérant,
dans lequel la vanne de détente (50) est commandée de telle sorte qu'une température de surface du troisième échangeur de chaleur (30) soit toujours supérieure à une température critique,
**caractérisé en ce que** le réfrigérant dans le circuit de pompe à chaleur (1) s'évapore par un apport de chaleur et est ensuite amené au troisième échangeur de chaleur (30) pour refroidir le convertisseur (31).

2. Procédé selon la revendication 1, **caractérisé en ce que** la température critique est calculée de telle sorte qu'elle correspond à une température de point de rosée de l'environnement du troisième échangeur de chaleur (30).

3. Procédé selon la revendication 1 ou 2, **caractérisé en ce que** la détermination de la température critique est effectuée au moins en partie à l'aide d'une humidité absolue mesurée de l'environnement du troisième échangeur de chaleur (30) ainsi qu'à l'aide d'une température de surface mesurée du troisième échangeur de chaleur (30), et/ou **en ce que** la détermination de la température critique est effectuée au moins en partie à l'aide d'une humidité absolue mesurée de l'environnement du troisième échangeur de chaleur (30) ainsi qu'à l'aide d'une température mesurée du réfrigérant à une sortie du premier échangeur de chaleur (10).

4. Procédé selon l'une quelconque des revendications précédentes, **caractérisé en ce que** la vanne de détente (50) est une vanne de détente, en particulier électronique, pouvant être pilotée en externe, un degré d'ouverture de la vanne de détente (50) pouvant être réglé indépendamment d'autres grandeurs caractéristiques du circuit de pompe à chaleur (1).

5. Procédé selon l'une quelconque des revendications précédentes, **caractérisé en ce qu'**une commande de la vanne de détente (50) est basée sur une logique floue, une régulation à structure variable ou sur une variation de valeurs de consigne.

6. Procédé selon la revendication 5, **caractérisé en ce que** la commande de la vanne de détente (50) implique la diminution d'une ouverture de passage de la vanne de détente (50) si la température de surface du troisième échangeur de chaleur (30) passe en dessous d'une température qui est supérieure d'une quantité définie à la température critique.

7. Procédé selon l'une quelconque des revendications précédentes, **caractérisé en ce que** le premier échangeur de chaleur (10) est un module évaporateur servant à faire évaporer le réfrigérant.

8. Procédé selon l'une quelconque des revendications précédentes, **caractérisé en ce que** le deuxième échangeur de chaleur (20) est un module condensateur servant liquéfier le réfrigérant.

9. Procédé selon l'une quelconque des revendications précédentes, **caractérisé en ce que** le convertisseur de fréquence (10) est conçu pour réguler un moteur de compresseur (42) du module compresseur (40) quant à une vitesse de rotation du moteur de compresseur (42).

10. Dispositif de refroidissement d'un convertisseur (31), en particulier d'un convertisseur de fréquence, dans un circuit de pompe à chaleur (1), comprenant
• un premier échangeur de chaleur (10), un deuxième échangeur de chaleur (20) et un troisième échangeur de chaleur (30) servant à échanger de l'énergie thermique entre un réfrigérant et un environnement de l'échangeur de chaleur (10, 20, 30) respectif,
• un module compresseur (40),
• une vanne de détente (50), la vanne de détente (50) étant disposée entre le premier échangeur de chaleur (10) et le deuxième échangeur de chaleur (20),
le premier échangeur de chaleur (10), le deuxième échangeur de chaleur (20), le troisième échangeur de chaleur (30), le module compresseur (40) ainsi que la vanne de détente (50) étant reliés les uns aux autres par un système de conduits (100) de telle sorte que le réfrigérant peut circuler dans le circuit de pompe à chaleur (1),
le troisième échangeur de chaleur (30) étant conçu pour extraire de l'énergie thermique du convertisseur (31) et pour libérer l'énergie thermique vers le réfrigérant, et
dans lequel le dispositif comprend en outre une unité de commande (200), l'unité de commande (200) étant conçue pour commander la vanne de détente (50) de telle sorte qu'une température de surface du troisième échangeur de chaleur (30) soit toujours supérieure à une température critique,
**caractérisé en ce que** le réfrigérant dans le circuit de pompe à chaleur (1) s'évapore par un apport de chaleur et est ensuite amené au troisième échangeur de chaleur (30) pour refroidir le convertisseur (31).

11. Dispositif selon la revendication 10, **caractérisé en ce qu'**il comprend en outre un capteur d'humidité servant à déterminer une humidité absolue de l'environnement du troisième échangeur de chaleur (30), ainsi qu'au moins un premier capteur de température servant à déterminer une température de surface du troisième échangeur de chaleur (30), et/ou au moins un deuxième capteur de température servant à déterminer une température du réfrigérant à une sortie du premier échangeur de chaleur (10), et/ou au moins un troisième capteur de température servant à déterminer une température du réfrigérant à une entrée du troisième échangeur de chaleur (30), et/ou un quatrième capteur de température servant à déterminer une température du réfrigérant en amont d'une entrée du troisième échangeur de chaleur (30).

12. Dispositif selon l'une quelconque des revendications 10 ou 11, **caractérisé en ce que** la vanne de détente (50) est une vanne de détente, en particulier électronique, pouvant être pilotée en externe, un degré d'ouverture de la vanne de détente (50) pouvant être réglé indépendamment d'autres grandeurs caractéristiques du circuit de pompe à chaleur (1).

13. Dispositif selon l'une quelconque des revendications 10 à 12, **caractérisé en ce que** le premier échangeur de chaleur (10) est un module évaporateur servant à faire évaporer le réfrigérant, et **en ce que** le deuxième échangeur de chaleur (20) est un module condensateur servant à liquéfier le réfrigérant.

14. Dispositif selon l'une quelconque des revendications 10 à 12, **caractérisé en ce que** le premier échangeur de chaleur (10) est un module condensateur servant à liquéfier le réfrigérant, et **en ce que** le deuxième échangeur de chaleur (20) est un module évaporateur servant à faire évaporer le réfrigérant.

15. Dispositif selon l'une quelconque des revendications 10 à 14, **caractérisé en ce que** le convertisseur (31) est conçu pour réguler un moteur de compresseur (42) du module compresseur (40) quant à une vitesse de rotation du moteur de compresseur (42).

16. Dispositif selon l'une quelconque des revendications 10 à 15, **caractérisé en ce que** le dispositif comprend en outre une vanne à 4 voies, la vanne à 4 voies (60) étant conçue pour commander le sens d'écoulement du réfrigérant dans le circuit de pompe à chaleur (1).

17. Dispositif selon la revendication 16, **caractérisé en ce que** la vanne à 4 voies (60) est conçue en particulier pour commander le sens d'écoulement du réfrigérant de telle sorte que le premier échangeur de chaleur (10) fonctionne au choix comme module évaporateur ou comme module condensateur, et le deuxième échangeur de chaleur (20) fonctionne en conséquence comme module condensateur ou comme module évaporateur du circuit de pompe à chaleur (1).
